# EUROPÄISCHE PATENTSCHRIFT

(11) **EP 0 998 723 B1**
(45) Veröffentlichungstag und Bekanntmachung des Hinweises auf die Patenterteilung: **09.04.2003**
(21) Anmeldenummer: 98947338.4
(22) Anmeldetag: 25.07.1998
(51) Int. Cl.: G06K 19/00

(54) **MODUL UND SEINE VERWENDUNG IN EINER CHIPKARTE**
MODULE AND ITS USE IN A CHIP CARD
MODULE ET SON USAGE DANS UNE CARTE A PUCE

(30) Priorität: 28.07.1997 DE 19732409; 05.08.1997 DE 19733777
(43) Veröffentlichungstag der Anmeldung: 10.05.2000
(73) Patentinhaber: Wendisch, Karl-Heinz, 33154 Salzkotten (DE)
(72) Erfinder: Wendisch, Karl-Heinz, 33154 Salzkotten (DE)
(74) Vertreter: Ostermann, Thomas, Dipl.-Ing.
(86) Internationale Anmeldenummer: DE9802097
(87) Internationale Veröffentlichungsnummer: WO99005643

(56) Entgegenhaltungen:
- EP-A- 0 671 705
- WO-A-98/06063
- WO-A-98/45804
- DE-A- 4 440 721
- US-A- 5 598 032

## Beschreibung

Aus der DE 195 00 925 A1 ist eine Chipkarte zur kontaktlosen Datenübertragung bekannt, die zum einen ein Chipmodul mit einem integrierten Schaltkreis und zum anderen ein Übertragungsmodul mit mindestens einem Übertragungselement zur Daten- und/oder Energieübertragung zwischen dem integrierten Schaltkreis und einem externen Gerät aufweist. Zur Bildung der Chipkarte wird in einem ersten Schritt das Übertragungsmodul in den Kartenkörper integriert. In einem zweiten Schritt wird dann das Chipmodul in eine dafür geschaffene Ausnehmung des Kartenkörpers eingesetzt und mit demselben verbunden. Zur elektrischen Ankopplung des Chipmoduls an das Übertragungsmodul werden die korrespondierenden Kontaktelemente des Chipmoduls einerseits und des Übertragungsmoduls andererseits aneinandergelegt. Dabei kann die elektrische Kontaktierung zwischen den korrespondierenden Kontaktelementen mittels Verlötung, durch Einbringen eines leitfähigen Klebers oder eines elastisch deformierbaren Körpers zwischen den Kontaktelementen hergestellt werden. Diese bekannten Kontaktierungsarten sind relativ aufwendig und unterliegen infolge starker Biegebeanspruchung der Chipkarte nur einer begrenzten Lebensdauer.

Weiterhin ist es bekannt, zur Herstellung einer kontaktlosen Chipkarte ein Chipmodul und ein Übertragungsmodul zu einem Modul zu verbinden und als Halbzeug bereitzuhalten, wobei die korrespondierenden Kontaktelemente von dem Chipmodul einerseits und dem Übertragungsmodul andererseits durch Löten bzw. Einbringen eines leitfähigen Klebers elektrisch miteinander verbunden sind. Dabei sind das Chip- und das Übertragungsmodul auf einem gemeinsamen Träger angebracht, der zwischen mindestens zwei Trägerschichten des Kartenkörpers eingebettet wird, so dass nach Laminieren der Trägerschichten die Chipkarte hergestellt ist.

Nachteilig an der bekannten Verbindungsart des Lötens ist, dass infolge der hohen Temperaturbelastung das aus einem thermoplastischen Kunststoff bestehende Übertragungsmodul sehr stark beansprucht wird, so dass eine Verformung desselben eintreten kann. Weiterhin ist der Lötvorgang relativ aufwendig, da zusätzlich Lötstoppmittel auf das Übertragungsmodul aufgebracht werden müssen.

Nachteilig an dem elektrisch leitenden Kleber ist, dass infolge Alterung desselben seine Leiteigenschaften abnehmen. Ferner ist die Dicke des elektrisch leitenden Klebers prozesstechnisch schwer auf einen konstanten Wert eingestellt werden kann. Die Einstellung eines konstanten Abstandes zwischen den korrespondierenden Kontaktelementen ist jedoch erforderlich, damit die Quererstreckung des Moduls in diesem Kontaktbereich mit der Tiefe der dafür vorgesehenen Ausnehmung des Kartenkörpers übereinstimmt.

Aus der WO 98/06063 A1 ist es zur Verbindung eines Chipmoduls mit einem Übertragungsmodul bekannt, ein Kontaktstück mit einer schneidenden Geometrie vorzusehen, wobei sich das Kontaktstück in einer Öffnung des Übertragungsmoduls erstreckt und eine elektrisch leitende Verbindung zu einer Antenne desselben herstellt.

Aus der US 5 598 032 A ist es zur Verbindung von einem Chipmodul mit einem Übertragungsmodul bekannt, metallische Zungen vorzusehen. Ein Einschneiden dieser Zungen durch die Trägerschicht des Chipmoduls ist nicht vorgesehen.

Aus der DE 44 40 721 A1 ist ein Modul bestehend aus zwei miteinander zu verbindenden flächigen Trägerschichten bekannt, bei der die beiden Trägerschichten auf einer zueinandergekehrten Seite zum einen spitz zulaufende Dorne und korrespondierend dazu auf der anderen Seite Aufnahmen aufweisen. Zur Verbindung der beiden Trägerschichten werden die Dorne korrespondierend zu den Aufnahmen positioniert, wobei sie nach Verbiegen derselben klemmend in den Aufnahmen gehaltert sind. Nachteilig an dem bekannten Modul ist, dass eine positionsgenaue Anlage der Träger-Trägerschichten zueinander gegeben sein muss. Anspruch 1 ist gegen dieses Dokument abgegrenzt.

Aufgabe der vorliegenden Erfindung ist es, ein Modul derart weiterzubilden, um auf einfache Weise eine zuverlässige und sichere elektrische Kontaktierung zwischen einem Chipmodul und einem weiteren Bauteil zu gewährleisten.

Zur Lösung dieser Aufgabe weist die Erfindung die Merkmale des Patentanspruchs 1 auf.

Der besondere Vorteil des erfindungsgemäßen Moduls besteht darin, dass lediglich Schneidelemente vorgesehen sein müssen, um eine klemmende Kontaktierung eines Chipmoduls mit einem Übertragungsmodul zu ermöglichen. Hierdurch kann eine einfache und zuverlässige elektrische Kontaktierung geschaffen werden.

Zusätzlich dient die Kontaktierung zur mechanischen Verbindung des Chipmoduls mit dem Übertragungsmodul. Vorteilhaft sind die Kontaktelemente keiner Temperaturbeanspruchung ausgesetzt. Die Verbindung erfolgt allein durch Ausnutzung einer Anpresskraft.

Auf einfache Weise kann ein Modul als Halbzeug hergestellt werden, das stets eine gleichbleibende Ausbildung aufweist. Dies wird insbesondere dadurch erzielt, dass durch die Kontaktelemente selbst die Verklemmung erzeugt wird. Es sind keine weiteren zusätzlichen Materialien oder Bauteile erforderlich, um die elektrische Kontaktierung herbeizuführen. Die Güte und die Ausbildung der Kontaktierung wird allein durch die Materialien der Kontaktelemente selbst bestimmt.

Nach einer besonderen Ausführungsform der Erfindung sind die Kontaktelemente des Chipmoduls jeweils als kronenförmige Schneidkontakte ausgebildet, wobei spitz zulaufende Zacken des Schneidkontaktes durch eine Trägerschicht des Übertragungsmoduls durchdrückbar sind. Durch Umlenkung und Andrücken derselben in Richtung des Kontaktelements des Übertragungsmoduls wird ein flächiger Presssitz der Zacken auf den Kontaktelementen des Übertragungsmoduls geschaffen.

Nach einer Weiterbildung der Erfindung sind die Kontaktelemente des Chipmoduls Bestandteil einer metallischen Chipträgerschicht. Vorzugsweise kann die Chipträgerschicht als Blechteil ausgebildet sein, wobei die Formgebung des Kontaktelements einfach durch Schneid- bzw. Biegewerkzeuge hergestellt werden kann.

Nach einer Weiterbildung der Erfindung wird das Chipmodul an einer den Kontaktelementen des Übertragungsmoduls abgewandten Seite mit demselben verbunden, so dass das Auftragen einer zwischenliegenden Isolationsschicht nicht erforderlich ist.

Vorteilhaft wird eine definierte Erhabenheit des Moduls gewährleistet, so dass die Aussparung des Kartenkörpers entsprechend anpassbar ist. Dadurch, dass die Chipträgerschicht von der Rückseite her an die Übertragungsträgerschicht andrückbar ist, wobei der Chip in eine korrespondierende Ausnehmung der Übertragungsmodulschicht eingreift, wird ein Modul mit vergleichsweise geringer Quererstreckung im Chipbereich geschaffen.

Ausführungsbeispiele der Erfindung werden nachfolgend anhand der Zeichnungen näher erläutert.

Es zeigen:
- Figur 1: Einen Teillängsschnitt durch ein Modul,
- Figur 2: eine Draufsicht auf ein Übertragungsmodul,
- Figur 3: eine perspektivische Ansicht eines Chipmoduls nach einem ersten Ausführungsbeispiel,
- Figur 4: einen Querschnitt durch ein Kontaktelement gemäß Figur 3,
- Figur 5: eine perspektivische Ansicht auf ein Chipmodul mit Kontaktelementen nach einem zweiten Ausführungsbeispiel und
- Figur 6: einen Längsschnitt durch eine Chipkarte mit einem erfindungsgemäßen Modul.

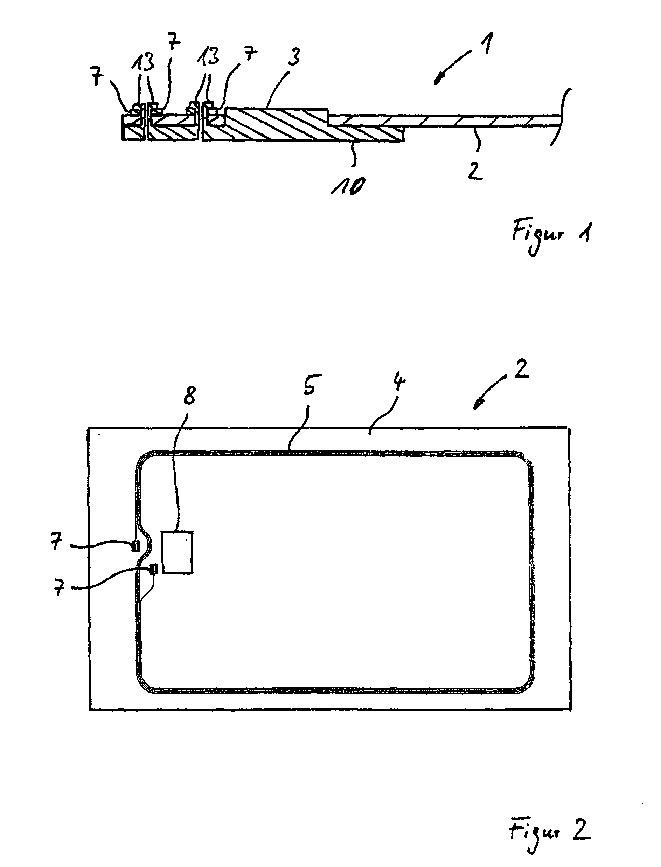

Figur 1 zeigt ein Modul 1, das aus einem Übertragungsmodul 2 und einem Chipmodul 3 zusammengesetzt ist. Die Verbindung zwischen dem Übertragungsmodul 2 und dem Chipmodul 3 erfolgt in einem Kontaktierungsbereich derselben.

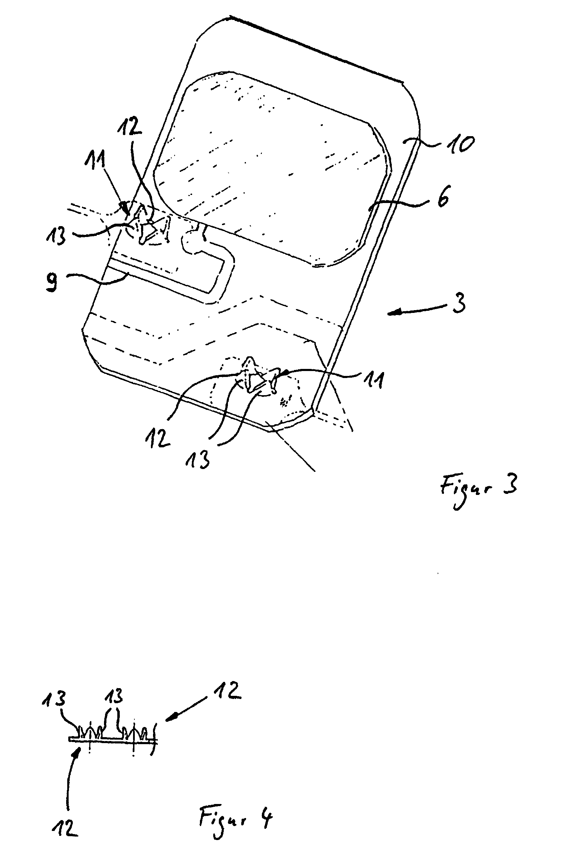

Wie aus Figur 2 zu ersehen ist, besteht das Übertragungsmodul 2 aus einer Übertragungsträgerschicht 4, auf der ein Übertragungselement 5 als strukturierte, insbesondere ätztechnisch, drucktechnisch oder laserstrukturiert aufgebrachte, Spule aufgedruckt oder als drahtgewickelte Spule aufgebracht ist. Das Übertragungselement 5 ist als Antenne ausgebildet und dient zur Daten- und/oder Energieübertragung zwischen einem in Figur 3 dargestellten Chip 6 und einem externen Gerät. Das mehrere Windungen aufweisende Übertragungselement 5 weist an seinen Enden flächige Kontaktelemente 7 auf. Alternativ können die Kontaktelemente 7 auch rund oder erhaben ausgebildet sein. Zur Aufnahme des Chips 6 weist das Übertragungsmodul 2 eine Aussparung 8 auf, die sich benachbart zu dem durch die Kontaktelemente 7 gebildeten Kontaktierungsbereich befindet. Die Übertragungsträgerschicht 4 besteht aus einem flexiblen Kunststoffmaterial aus PVC, PC oder ABS mit einer Dicke von mindestens 150 µm, vorzugsweise 200 bis 300 µm.

Wie aus Figur 3 zu ersehen ist, besteht ein Chipmodul 3 aus einer dünnen quaderförmigen Chipträgerschicht 10, die vorzugsweise aus einem metallischen Werkstoff gebildet wird. Auf der Chipträgerschicht 10 ist der integrierte Schaltkreis 6 aufgebracht, dessen elektrische Anschlüsse durch Kontaktelemente 11 gebildet werden. Die Kontaktelemente 11 sind als kronenförmige Schneidkontakte 12 mit rechtwinklig abstehenden und spitz zulaufenden Zacken 13 ausgebildet. Die Ausbildung der Kontaktelemente 11 erfolgt durch entsprechende Schneid- und Biegewerkzeuge. Durch Ausstanzungen 9 sind die Kontaktelemente 11 voneinander getrennt und isoliert. Das Chipmodul 3 kann als Zwischenerzeugnis auf einer Rolle bereitgehalten werden.

Zur Herstellung einer elektrischen und mechanischen Verbindung zwischen dem Chipmodul 3 und dem Übertragungsmodul 2 werden die Übertragungsträgerschicht 4 und die Chipträgerschicht 10 derart aneinandergelegt, dass der integrierte Schaltkreis 6 mit der Aussparung 8 fluchtet und die Zacken 13 der Schneidkontakte 12 korrespondierend zu den Kontaktelementen 7 an der Rückseite der Übertragungsträgerschicht 4 anliegen. Durch Ausübung einer Kraft in Richtung der Kontakelemente 7 werden die Zacken 13 der Kontaktelemente 11 durch die Übertragungsträgerschicht 4 bzw. durch das korrespondierenden Kontaktelemente 7 hindurchgedrückt, so dass die Übertragungsträgerschicht 4 und die Chipträgerschicht 10 flächig aneinanderliegen. Durch geeignete Biegewerkzeuge werden die Zacken 13 umgebogen und auf die Fläche des entsprechenden Kontaktelements 7 gedrückt. Die Zacken 13 liegen plan unter Bildung eines Preßsitzes auf den Kontaktelementen 7 an. Der Preßsitz wird dadurch erhöht, dass die Dicke der Zacken 13 wesentlich größer ist als die Dicke der Kontaktelemente 7, vorzugsweise doppelt so groß wie die Quererstreckung der Kontaktelemente 7. Es wird eine dauerhafte klemmende Verbindung zwischen den Kontaktelementen 7 und 11 geschaffen, wobei eine durch die Dicke der Kontaktelemente 7 und 11 vorgegebene Erhabenheit des Moduls 1 gebildet wird.

Alternativ kann die Chipträgerschicht 10 lediglich Einschnitte, insbesondere kreuzförmige Einschnitte, aufweisen. Erst bei der Herstellung der Verbindung zwischen dem Chipmodul 3 und dem Übertragungsmodul 2 wird durch Auftulpen bzw. Verschwenken der durch die Einschnitte gebildeten Zacken 13 aus einer mit der Chipträgerschicht 10 gemeinsamen Ebene das Kontaktelement 11 gebildet, das dann korrespondierend zum Kontaktelement 7 in Anlage gebracht wird. Bei dieser Ausführungsform erfolgt die Bildung der Schneidkontakte 12 also erst unmittelbar bei Verbindung des Chipmoduls 3 mit dem Übertragungsmodul 2. Das Chipmodul 3 kann somit im wesentlichen ohne abstehende Kontaktelemente 11 bereitgehalten werden, so dass der herstellungstechnische Aufwand reduziert ist.

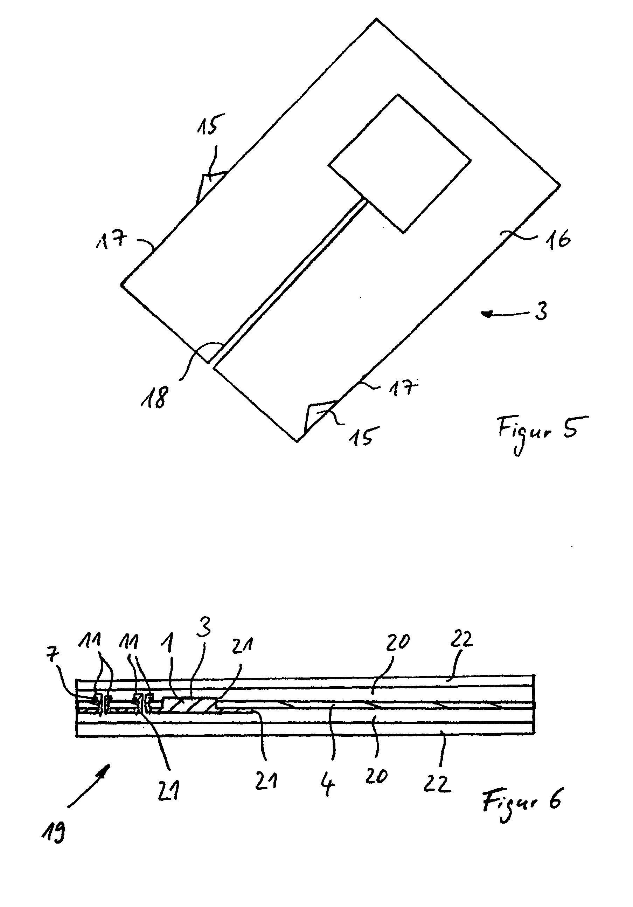

Nach einer weiteren Ausführungsform des Chipmoduls 3 gemäß Figur 5 sind die Kontaktelemente als Kontaktnasen 15 ausgebildet. Die Kontaktnasen 15 sind jeweils korrespondierend zu einer entsprechenden Kontaktfläche des Übertragungsmoduls an einem Rand 17 einer Chipträgerschicht 16 angeordnet. Wie aus Figur 5 ersichtlich ist, sind die Kontaktnasen 15 dreieckförmig ausgebildet. Alternativ können sie auch bogenförmig ausgebildet sein. Wichtig ist, dass die Fläche der Kontaktelemente 15 so groß ist, dass nach Umbiegung derselben eine ausreichend große Kontaktfläche gebildet wird, die flächig auf dem korrespondierenden Kontaktelement des Übertragungsmoduls aufliegt.

Ein Schlitz 18 trennt die Kontaktelemente 15 voneinander, so dass keine elektrische Verbindung zwischen ihnen besteht. Durch Verschwenken der Kontaktnasen 15 um einen nicht dargestellten Rand des Übertragungsmoduls kann eine klemmende elektrische und zugleich mechanische Verbindung zwischen der Chipträgerschicht 16 und dem Übertragungsmodul geschaffen werden.

Alternativ können die Kontaktelemente des Chipmoduls auch durch das Vorsehen von randseitigen Einschnitten in eine quaderförmige Chipträgerschicht gebildet werden, so dass weniger Materialaufwand erforderlich ist.

Alternativ kann die Ausbildung zumindest eines Kontaktelements durch den Verlauf des isolierenden Schlitzes gebildet werden, so dass der herstellungstechnische Aufwand weiter verringert werden kann. Die Kontaktelemente können also an einer beliebigen Stelle der Chipträgerschicht angeordnet sein, vorzugsweise aber in einem Randbereich. Sie sind als Teil der Chipträgerschicht ausgebildet, so dass der Chipträgerschicht eine doppelte Funktion zukommt. Sie dient zum einen als Trägerschicht für den Chip und zum anderen zur Ausbildung von Kontaktelementen. Die Chipträgerschicht ist aus einem elektrisch leitenden Material gebildet, vorzugsweise aus Blech.

Die oben beschriebenen Module dienen jeweils als Halbzeug für die Herstellung einer Chipkarte 19, wie sie in Figur 6 dargestellt ist. Die Chipkarte 19 kann in der Laminiertechnik hergestellt werden, wobei sich jeweils benachbart zu der Übertragungsträgerschicht 4 und der Chipträgerschicht 10 eine innere Kernschicht 20 anschließt. Die Kernschichten 20 weisen jeweils zu den Erhebungen der Übertragungsträgerschicht 4 und der Chipträgerschicht 10 korrespondierende Ausnehmungen 21 auf. Außenseitig schließen sich an die Kernschichten 20 jeweils eine Deckschicht 22 an, deren Außenflächen vorzugsweise mit einem Aufdruck versehen sind. Die Kernschichten 20 und die Deckschichten 22 können aus einem ABS-, PC- oder PVC-Material bestehen.

## Patentansprüche

1. Modul, insbesondere zur Verwendung in Chipkarten, enthaltend ein Chipmodul (3) mit einem integrierten Schaltkreis (6) einerseits und ein Übertragungsmodul (2) mit einem Übertragungselement (5) zur Datenund/oder Energieübertragung zwischen dem integrierten Schaltkreis (6) und einem externen Gerät oder vice versa andererseits, wobei das Chipmodul (3) und das Übertragungsmodul (2) jeweils Trägerschichten (4, 10) und Kontaktelemente (7, 11) zur elektrischen Verbindung miteinander aufweisen, wobei das Chipmodul (3) oder das Übertragungsmodul (2) verbiegbare Verbindungselemente (12) aufweist zur formschlüssigen mechanischen und elektrischen Verbindung miteinander, wobei das Verbindungselement (12) an einer Seite der Trägerschicht (4, 10) klemmend anlegbar ist, **dadurch gekennzeichnet, dass** das Verbindungselement (12) als ein solches Schneidelement ausgebildet ist, dass es nach dem Hindurchdrücken durch die Trägerschicht (4, 10) des Chipmoduls (3) bzw. des Übertragungsmoduls (2) unter flächiger Anlage des Chipmoduls (3) an dem Übertragungsmodul (2) anlegbar ist.

2. Modul nach Anspruch 1, **dadurch gekennzeichnet, dass** das Schneidelement (12) als Kontaktelement (11) des Chipmoduls (3) ausgebildet ist und abragende Zacken (13) aufweist, die in der Kontaktierungsposition unter Verbiegung derselben an dem korrespondierenden Kontaktelement (7) des Übertragungsmoduls (2) anliegen.

3. Modul nach Anspruch 1 oder 2, **dadurch gekennzeichnet, dass** das Chipmodul (3) eine aus einem metallischen Werkstoff bestehende Chipträgerschicht (10) aufweist, wobei die Kontaktelemente (11) des Chipmoduls (3) jeweils einstückig mit der Chipträgerschicht (10) verbunden sind.

4. Modul nach einem der Ansprüche 1 bis 3, **dadurch gekennzeichnet, dass** die Chipträgerschicht (10) aus einem Blechmaterial besteht, wobei die Kontaktelemente (11) des Chipmoduls (3) durch Ausstanzen gebildet sind.

5. Modul nach einem der Ansprüche 1 bis 4, **dadurch gekennzeichnet, dass** die Kontaktelemente (11) des Chipmoduls (3) randseitig am Chipmodul (3) als abstehende Kontaktlappen (15) angeordnet sind.

6. Verwendung eines Moduls nach einem der Ansprüche 1 bis 5 in einer Chipkarte.

## Claims

1. Module, particularly for use in chip cards, comprising a chip module (3) with an integrated circuit (6) on one hand and a transmission module (2) with a transmission element (5) for transmitting data and/or energy between the integrated circuit (6) and an external unit or vice versa on the other hand, wherein said chip module (3) and said transmission module (2) each comprise carrier substrates (4, 10) and contact elements (7, 11) for electric interconnection; wherein said chip module (3) or said transmission module (2) is provided with flexible interconnection elements (12) to establish positive mechanical and electric connection therebetween; and wherein the interconnection element (12) is clampingly engageable with one side of the carrier substrate (4, 10);
**characterized by** the fact that
the interconnection element (12) is provided in the form of a cutting element such that on having been pressed through the carrier substrate (4, 10) of the chip module (3) or the transmission module (2), respectively, said interconnection element will act to establish full-face engagement between said chip module (3) and said transmission module (2).

2. Module according to Claim 1, **characterized by** the fact that the cutting element (12) is provided as contact element (11) of said chip module (3) and comprises protruding prongs (13) which while in bent contacting position are engaging the corresponding contact element (7) of said transmission module (2).

3. Module according to Claims 1 or 2, **characterized by** the fact that said chip module (3) comprises a chip carrier substrate (10) formed of metallic material, wherein the contact elements (11) of said chip module are integrally secured to the chip carrier substrate (10).

4. Module according to any of the preceding Claims 1 to 3, **characterized by** the fact that the chip carrier substrate (10) is formed of metal sheet material, wherein the contact elements (11) of said chip module (3) have been formed by punching.

5. Module according to any of the preceding Claims 1 to 4, **characterized by** the fact that the contact elements (11) of said chip module (3) are provided in the form of protruding contact tabs (15).

6. Use of the module according to Claims 1 to 5 in a chip card.

## Revendications

1. Module, notamment pour l'utilisation dans des cartes à puce, comprenant, d'une part, un module à puce (3) avec un circuit de commutation intégré (6) et, d'autre part, un module de transfert (2) avec un élément de transfert (5) pour la transmission de données et / ou d'énergie entre le circuit de commutation intégré (6) et un appareil externe ou vice-versa, le module à puce (3) et le module de transfert (2) présentant chacun des couches de support (4, 10) et des éléments de contact (7, 11) pour les connecter électriquement ensemble, le module à puce (3) ou le module de transfert (2) présentant des éléments de liaison flexibles (12) pour les relier ensemble, mécaniquement et électriquement, par assemblage géométrique, l'élément de liaison (12) pouvant être assemblé par pinçage à un côté de la couche de support (4, 10), **caractérisé en ce que** l'élément de liaison (12) est conçu en tant qu'organe coupant, que celui-ci, après avoir été pressé à travers la couche de support (4, 10) du module à puce (3) resp. du module de transfert (2), vient porter, le module à puce (3) étant appliqué à plat sur le module de transfert (2).

2. Module selon la revendication 1, **caractérisé en ce que** l'élément coupant (12) est conçu en tant qu'élément de contact (11) du module à puce (3) et présente des pointes en saillie (13) qui, en position d'établissement de contact, viennent porter, tout en se déformant, contre l'élément de contact (7) correspondant du module de transfert (2).

3. Module selon la revendication 1 ou 2, **caractérisé en ce que** le module à puce (3) présente une couche de support (10) en matière métallique, les éléments de contact (11) du module à puce (3) étant reliés chacun d'une seule pièce à la couche de support (10) de la puce.

4. Module selon l'une des revendications 1 à 3, **caractérisé en ce que** la couche de support (10) de la puce (10) est en tôle, les éléments de contact (11) du module à puce (3) étant formés par poinçonnage.

5. Module selon l'une des revendications 1 à 4, **caractérisé en ce que** les éléments de contact (11) du module à puce (3) sont disposés, sur les bords du module à puce (3), en forme de pattes de contact (15).

6. Utilisation d'un module selon l'une des revendications 1 à 5 dans une carte à puce.
